Europäisches Patentamt

European Patent Office

Office européen des brevets

(11) Publication number: **0 068 786**
**B1**

(12) EUROPEAN PATENT SPECIFICATION

(45) Date of publication of patent specification: **09.11.88**

(51) Int. Cl.⁴: **H 01 L 27/14**

(21) Application number: **82303232.1**

(22) Date of filing: **22.06.82**

(54) Improvements in or relating to detector arrays.

(30) Priority: **24.06.81 GB 8119462**

(43) Date of publication of application:
**05.01.83 Bulletin 83/01**

(45) Publication of the grant of the patent:
**09.11.88 Bulletin 88/45**

(84) Designated Contracting States:
**AT BE CH DE FR IT LI LU NL SE**

(56) References cited:
**DE-A-2 259 008**
**GB-A-1 453 341**
**US-A-4 112 316**
**US-A-4 115 692**
**US-A-4 190 851**

(73) Proprietor: **PLESSEY OVERSEAS LIMITED**
**Vicarage Lane**
**Ilford Essex IGI 4AQ (GB)**

(72) Inventor: **Gooding, John Norman**
**52 Church Road**
**Braunston Daventry Northants (GB)**

(74) Representative: **Sorenti, Gino**
**Intellectual Property Department The Plessey**
**Company plc 2-60 Vicarage Lane**
**Ilford Essex IG1 4AQ (GB)**

Courier Press, Leamington Spa, England.

## Description

The present invention relates to detector arrays and more particularly to detector arrays including a charge coupled device (C.C.D.) as an interface to further electronic processing circuitry.

Charge Coupled Devices (CCD's) have been accepted as an attractive means of providing the parallel to serial data stream conversion necessary to read out the information from any array of detectors. A CCD operate on charge packets which are positive (for a P-channel device) or negative (for an N-channel Device) but no device can accept both polarities of charge. Some detectors (e.g. CMT) generate a bias charge which is modulated with signal information. This charge can be fed directly into the CCD input, thus making a direct coupling of the CMT detector and the CCD possible.

Other detectors (e.g. pyroelectric detectors) are not net sources of charge. Thus to enable this type of detector to be coupled to a CCD in a direct manner a bias charge generator is required. This has been done in the past by providing a current from a voltage source via a resistor (of e.g. US—A—4115692). This is not a practical solution for an array since the currents involved are so small.

The present invention has an object to provide a solution to this problem by a solution which is compatible with microelectric technology.

According to the present invention there is provided an array of detection devices, each detection device being coupled to a first charge coupled device via an individual second charge coupled device, each said second charge coupled device having a charge injection means attached there to for supplying a fixed charge on each clock cycle to said second charge coupled device for addition to any charge created by the detection device attached to said individual second charge coupled device.

In a preferred embodiment the array of detection devices comprises pyroelectric detectors in a matrix arrangement.

The present invention will now be described by way of example with reference to the accompanying drawings in which:—

Figure 1 shows in diagramatic form a portion of a line of a pyroelectric matrix display, according to the present invention, and

Figure 2 shows a diagramatic form a complete matrix display incorporating the invention.

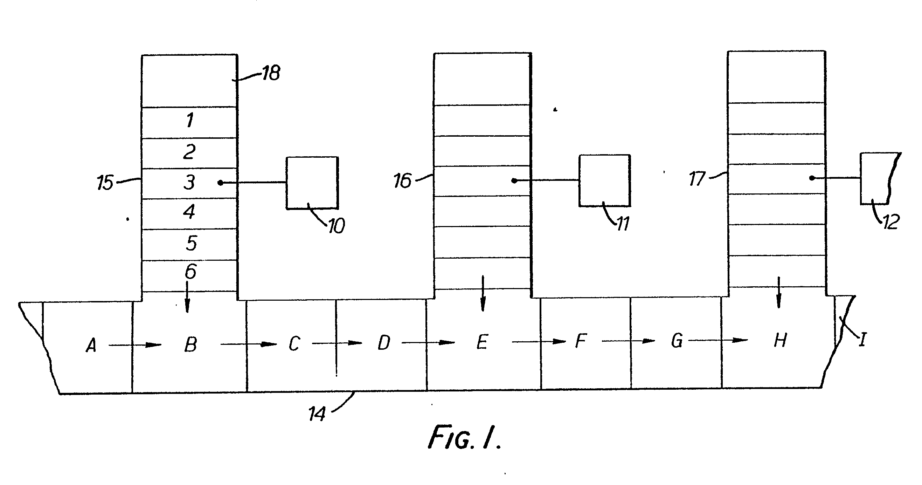

Referring now to figure 1 pyroelectric detectors 10, 11 and 12 are shown. Detector 12 is only partially shown to indicate that a plurality of detectors may be connected to the first charge coupled device 14 via their individual second charge coupled devices 15, 16, 17 etc.

Since the arrangement of each detector and charge coupled device is identical only the arrangement of detector 10 will be described.

The detector 10 is connected to a stage of the charge coupled device 15 in such a manner that any charge collected by the detector 10 will be fed directly into the stage of the charge coupled device 15. For clarity the stages of the device 15 are numbered 1 to 6 and as can be seen the detector 10 is connected to stage 3.

For explanation the stages of the first charge coupled device 14 are given the reference letters A to I and the stages A and I are shown only partially to indicate that the device has more stages than those shown.

At the top of each charge coupled device 15 is an input stage 18 which generates a fixed bias charge which is injected into the first stage 1 of the charge cupled device 15 during each clock cycle. The fixed bias charge is then transferred in the normal manner along the C.C.D. 15 until it reachesd stage 3 at which stage it is combined with the charge on the detector 10 to produce a modified charge packet which is transferred by successive clock pulses to stage 6 to C.C.D. 15 and then to stage B of C.C.D. 14. The modified charge packet is then transferred along C.C.D. 14 by further clock pulses.

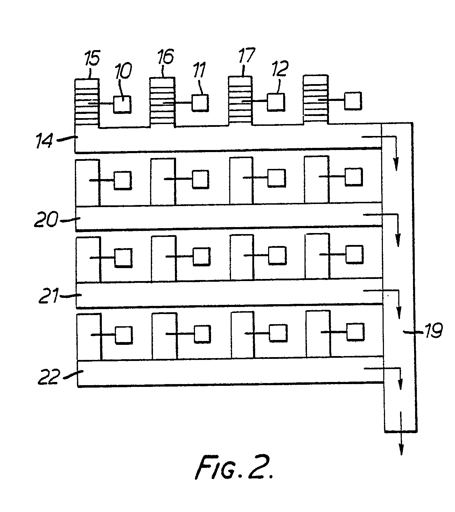

Referring now to figure 2 the charge coupled device 14 may be connected to a further charge coupled device 19 which receives inputs from further similar charge coupled devices 20, 21, and 22 and provides by suitable clock pulse trains a single output for the 4 × 4 detector array.

## Claims

1. An array of detection devices, each detection device (10, 11, 12) being coupled to a first charge coupled device (14) via an individual second charge coupled device (15, 16, 17), each said second charge coupled device having a charge injection means (18) attached there-to for supplying a fixed charge on each clock cycle to said second charge coupled device for addition to any charge created by the detection device attached to said individual second charge coupled device.

2. An array of detection devices as claimed in claim 1 in which the array of detection devices comprises pyroelectric detectors in a matrix arrangement.

3. An array of detection devices as claimed in claim 2 including a third charge coupled device (19) connected to the outputs of each respective first charge coupled device (14, 20, 21, 22) to receive the signals from all detectors.

## Patentansprüche

1. Detektionselementen-Feld, bei dem jedes Detektionselement (10, 11, 12) an ein erstes ladungsgekoppeltes Speicherelement (14) über ein individuelles, zweites ladungsgekoppeltes Speicherelement (15, 16, 17) gekoppelt ist, und mit jedem besagter zweiten ladungsgekoppelten Speicherelemente Ladungsinjiziermittel (18) verbunden sind, um eine bestimmte Ladung an besagtes zweites ladungsgekoppeltes Speicherelement, auf jeden Taktzyklus hin, zuzuspeisen, zur Addition mit jeglicher Ladung, welche durch das Detektionselement erzeugt wird, welches mit besagtem individuellen zweiten ladungsgekoppelten Speicherelement verbunden ist.

2. Feld nach Anspruch 1, welches pyro-elektrische Detektoren in einer Matrixanordnung umfasst.

3. Feld nach Anspruch 2, ein drittes ladungsgekoppeltes Speicherelement (19) umfassend, welches mit den Ausgängen jedes entsprechenden ersten ladungsgegekoppelten Speicherelements (14, 20, 22) verbunden ist, um die Signale von allen Detektoren zu empfangen.

**Revendications**

1. Arrangement de dispositifs de détection, chaque dispositif de détection (10, 11, 12) étant couplé à un premier dispositif (14) à couplage par charges par un second dispositif individuel (15, 16, 17) à couplage par charges, chaque second dispositif à couplage par charges ayant un dispositif d'injection de charges (18) qui lui est fixé afin qu'il transmette une charge fixe à chaque cycle d'horloge au second dispositif à couplage par charges, cette charge étant destinée à s'ajouter à une charge éventuelle créée par le dispositif de détection fixé au second dispositif individuel à couplage par charges.

2. Arrangement de dispositifs de détection selon la revendication 1, dans lequel l'arrangement des dispositifs de détection comporte des détecteurs pyroélectriques ayant un arrangement matriciel.

3. Arrangement de dispositifs de détection selon la revendication 2, comprenant un troisième dispositif (19) à couplage par charges connecté aux sorties de chaque premier dispositif (14, 20, 21, 22) à couplage par charges afin qu'il reçoive les signaux de tous les détecteurs.

FIG. I.

FIG. 2.